Europäisches Patentamt

European Patent Office

Office européen des brevets

(11) Publication number: **0 637 876 A1**

## EUROPEAN PATENT APPLICATION

(21) Application number: **94110942.3**

(22) Date of filing: **14.07.94**

(51) Int. Cl.6: **H03L 7/183**

(30) Priority: **03.08.93 US 100951**

(43) Date of publication of application:
**08.02.95 Bulletin 95/06**

(84) Designated Contracting States:
**DE FR GB IE IT**

(71) Applicant: **MOTOROLA, INC.**
**1303 East Algonquin Road**
**Schaumburg, IL 60196 (US)**

(72) Inventor: **Sanchez, Hector**
**4506 Tamarack Trail**
**Austin,**
**Texas 78727 (US)**
Inventor: **Alvarez, Jose**
**15346 English River Loop**
**Leander,**
**Texas 78641 (US)**
Inventor: **Gerosa, Gianfranco**
**6506 Torrey Pines Cove**
**Austin,**
**Texas 78746 (US)**

(74) Representative: **Hudson, Peter David et al**
**Motorola**
**European Intellectual Property**
**Midpoint**
**Alencon Link**
**Basingstoke,**
**Hampshire RG21 1PL (GB)**

(54) **A phase locked loop and method of operation.**

(57) A phase locked loop (22) that generates an output clock signal has a phase/frequency circuit (12), a charge pump circuit (14), a voltage controlled oscillator circuit (16), a first divide-by circuit (24) and a second divide-by circuit (18). The phase/frequency circuit generates a first control signal responsive to a predetermined phase relationship between a first and a second clock signal. The charge pump circuit generates a voltage responsive to the first control signal. The voltage controlled oscillator circuit generates a third clock signal responsive to the voltage. The first and second divide-by circuits serially reduce the frequency of the third clock cycle by a first and a second ratio, respectively. The first ratio is controlled by a second control signal. The output of the first divide-by circuit generates the output clock signal. The output of the second divide-by circuit generates the first clock signal. The phase locked loop has a less onerous VCO bandwidth requirement for a given operating environment and has a reduced phase lock time when changing ratios of input to output clock frequency.

FIG.2

Field of the Invention

The present invention generally relates to phase locked loops, and more specifically to a phase locked loop with improved frequency bandwidth.

Background of the Invention

Phase locked loops (PLLs) are a class of devices that match the phase and frequency of a reference clock signal with the phase and frequency of an output clock signal. PLLs are widely used in frequency modulation (FM) radio and digital computing applications.

Some PLLs generate an output clock signal with a frequency which is some multiple of the reference clock signal frequency. This modification may be advantageous in radio applications in which the radio transmits and receives at some multiple of a commonly available reference clock signal. This modification may also be advantageous to data processing systems in which the data processor operates at some multiple of an input reference clock signal, such as a bus clock signal.

Divide-by-P circuits (where P is an integer) can be used to generate the frequency modification described above. A divide-by-P circuit can be interposed between the reference clock signal and the PLL's input to generate an output clock signal that is (1/P) times as slow as the reference clock signal. Conversely, a divide-by-M circuit (where M is an integer) can be interposed in the feedback loop of the output clock signal to generate an output clock signal that is (M) times as fast as the reference clock signal.

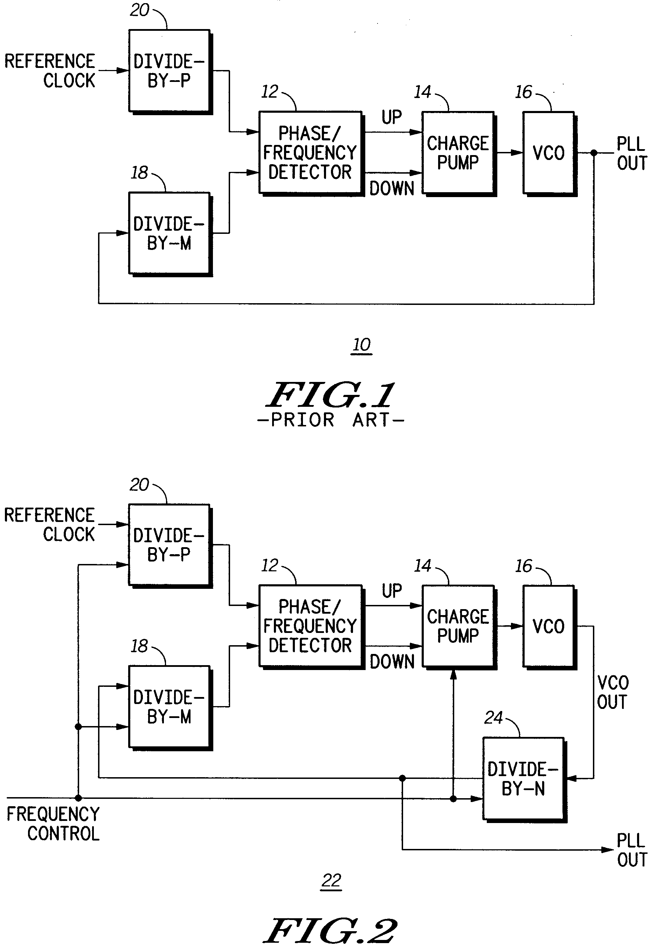

FIG. 1 depicts a block diagram of a phase locked loop 10 known in the art. PLL 10 has a phase/frequency detector 12, a charge pump 14, a voltage controlled oscillator (hereafter simply "VCO") 16, a divide-by-M circuit 18 and a divide-by-P circuit 20, where M and P are integers.

The operation of PLL 10 is known by one skilled in the art. In general, PLL 10 generates an output clock signal, PLL OUT, that has a predetermined phase and frequency relationship to an input signal REFERENCE CLOCK. In particular, PLL 10 dynamically adjusts the phase and frequency of the output clock signal PLL OUT to match the phase and frequency of the reference clock signal.

Phase/frequency detector 12 receives the two clock signals and generates UP and DOWN control signals. If the clock signal output by divide-by-M circuit 18 has a lower frequency than the clock signal output by divide-by-P circuit 20, then phase/frequency detector 12 asserts the UP signal. Conversely, if the clock signal output by divide-by-M circuit 18 has a higher frequency than the clock signal output by divide-by-P circuit 20, then phase/frequency detector 12 asserts the DOWN signal. When the two clock signals have substantially the same phase and frequency, then phase/frequency detector 12 asserts neither signal.

Charge pump 10 charges or discharges a node (not shown) responsive to the output signals UP and DOWN of phase/frequency detector 14. Typically, the node is connected to ground through a resistor and a capacitor connected in series. Charge pump 10 charges the node when the UP control signal is asserted by sourcing an electrical current to the node. Charge pump 10 discharges the node when the DOWN control signal is asserted by sinking an electrical current from the node.

VCO 16 generates a periodic clock signal (labeled PLL OUT) responsive to the voltage present on the node of charge pump 14. VCO 16 may have within it a ring oscillator connected to a first and a second power rail through a first and a second transistor, respectively. Generally, an increase in the voltage present on output node 12 causes the conductivity of the first or second transistors to increase, thereby increasing the oscillation frequency of the ring oscillator. Conversely, a decrease in the voltage present on output node 12 causes the conductivity of the first or second transistors to decrease, thereby decreasing the oscillation frequency of the ring oscillator.

The output of VCO 16 generates the output of PLL 22 (labeled PLL OUT). Divide-By-M circuit 18 receives the signal PLL OUT and reduces the frequency of the signal by an integer ratio M. Divide-By-P circuit 20 receives the signal REFERENCE CLOCK and reduces the frequency of the signal by an integer ratio P. The output of divide-by-M circuit 18 and divide-By-P circuit 20 are input to phase/frequency detector 12. It is these two signals which phase/frequency detector 12 aligns.

PLL 10 may generate an output clock signal that has a frequency different from the reference clock signal with the addition of divide-by-M circuit 18 or divide-by-P circuit 20. The frequency of the output clock signal, $\nu_{PLL\ OUT}$ is given by the relation:

$$\nu_{PLL\ OUT} = (M/P)\nu_{IN}$$

where M and P are the integers described above and where $\nu_{IN}$ is the frequency of REFERENCE CLOCK.

The frequency of a PLL's output clock signal may be varied by inserting a programmable divide-by-M circuit or programmable divide-by-P circuit in the appropriate location. A PLL incorporating such a divider may generate a clock signal with different frequencies depending upon the settings of the inserted divider circuit. This flexibility may be required or may be simply desirable depending upon the application. For instance, in many FM radio systems, the associated PLL must be able to generate different output clock frequencies for different operating frequencies. In data processing systems, it may be desirable to generate an output clock signal with the maximum permissible frequency allowed by the data processor independent of the input clock signal. A programmable PLL allows a data processor to operate at its maximum clock speed in a wide variety of circumstances. In this latter case, the setting of the divide-by circuits may be adjusted to increase the ratio (M/P) as the frequency of the input clock signal decreases.

The operating characteristics of the VCO are typically the limiting constraints of a PLL. The bandwidth of the VCO is limited by the maximum frequency of the worst case manufacturing result and the minimum frequency of the best case manufacturing result. The difference of these two frequencies is the bandwidth of the VCO for the particular manufacturing process. Therefore, a designer trying to increase the bandwidth of a PLL has two design choices: (1) he can modify or "tweak" his manufacturing process to improve circuit performance; or (2) he can use a divide-by-M circuit and increase the value of M. Tweaking manufacturing processes is an expensive solution. Further, the results of a process tweak are difficult to predict. The use of a divide-by-M circuit can increase the effective bandwidth of a PLL. Unfortunately, as M increases, the rate at which the reference and output clock signals are compared is decreased. This decrease increases the PLLs sensitivity to noise and decreases its response time to changes in frequency of either clock signal. Also, a VCO requires a certain number of clock cycles to match each new set of clock signals. Generally, the greater the difference between phase and frequency of the two clock signals, the greater is the "relock" time needed to match the two signals. Therefore, a PLL switching from $M = 2$ to $M = 1$ or vice versa will require a relatively long time to rematch its two clock signals.

## Summary of the Invention

In accordance with the present invention, there is disclosed a phase locked loop having a combination of divide-by circuits which substantially eliminates disadvantages of phase locked loops.

A phase locked loop that generates an output clock signal has a phase/frequency circuit, a charge pump circuit, a voltage controlled oscillator circuit, a first divide-by circuit and a second divide-by circuit. The phase/frequency circuit generates a first control signal responsive to a predetermined phase relationship between a first and a second clock signal. The charge pump circuit generates a voltage responsive to the first control signal. The voltage controlled oscillator circuit generates a third clock signal responsive to the voltage. The first and second divide-by circuits serially reduce the frequency of the third clock cycle by a first and a second ratio, respectively. The first ratio is controlled by a second control signal. The output of the first divide-by circuit generates the output clock signal. The output of the second divide-by circuit generates the first clock signal.

In addition, a method of generating an output clock signal is described. The method comprises the steps of receiving a first clock signal and a second clock signal at a phase/frequency circuit and generating a first control signal responsive to a predetermined phase relationship between the first and second clock signals. The method also has the steps of generating a voltage by a charge pump circuit responsive to the first control signal and generating a third clock signal by a voltage controlled oscillator responsive to the voltage. Finally, the method has the steps of generating an output clock signal by a first divide-by circuit and generating the first clock signal by a second divide-by circuit. The ratio of the frequency of the output clock signal and the frequency of the third clock signal are responsive to a second control signal. The ratio of the frequency of the first clock signal and the frequency of the output clock signal are a predetermined ratio.

## Brief Description of the Drawings

The features and advantages of the present invention will be more clearly understood from the following detailed description taken in conjunction with the accompanying FIGURES where like numerals refer to like and corresponding parts and in which:

FIG. 1 depicts a block diagram of a phase locked loop known in the art;

FIG. 2 depicts a block diagram of a phase locked loop constructed in accordance with the present invention;

FIG. 3 depicts in tabular form four configurations of the PLL illustrated in FIG. 2;

FIG. 4 depicts in tabular form three configurations of the PLL illustrated in FIG. 2.

## Detailed Description of a Preferred Embodiment

FIG. 2 depicts a block diagram of a phase locked loop 22 constructed in accordance with the present invention. PLL 22 has a phase/frequency detector 12, a charge pump 14, a voltage controlled oscillator (hereafter simply "VCO") 16, a divide-by-M circuit 18, a divide-by-P circuit 20 and a divide-by-N circuit 24, where M, N and P are positive real numbers. The combination of divide-by circuits 18 and 24 in the PLL feedback loop increases the difference between highest and lowest input frequency for a given VCO bandwidth, increases the number of possible ratios between input and output frequency and reduces re-lock time. Consequently, a manufacturing process that ordinarily yields a VCO with a narrow bandwidth may be used to manufacture a PLL with a much larger input frequency range.

The operation of the individual pieces of PLL 22 and the overall function of PLL 22 are known by one skilled in the art. In general, PLL 22 generates an output clock signal, PLL OUT, that has a predetermined phase and frequency relationship to an input signal REFERENCE CLOCK. In particular, PLL 22 dynamically adjusts the phase and frequency of the output clock signal to match the phase and frequency of the reference clock signal or adjusts the phase and frequency of the output clock signal to match the phase and frequency of a multiple of the reference clock signal.

Phase/frequency detector 12 receives the two clock signals and generates UP and DOWN control signals. If the clock signal output by divide-by-M circuit 18 has a lower frequency than the clock signal output by divide-by-P circuit 20, then phase/frequency detector 12 asserts the UP signal (or a predetermined edge of the clock signal output by divide-by-M circuit 18 lags the same edge of the clock signal output by divide-by-P circuit 20). Conversely, if the clock signal output by divide-by-M circuit 18 has a higher frequency than the clock signal output by divide-by-P circuit 20, then phase/frequency detector 12 asserts the DOWN signal (or a predetermined edge of the clock signal output by divide-by-M circuit 18 leads the same edge of the clock signal output by divide-by-P circuit 20). When the two clock signals have substantially the same phase and frequency, then phase/frequency detector 12 asserts neither signal.

Charge pump 10 charges or discharges a node (not shown) responsive to the output signals UP and DOWN of phase/frequency detector 14. Typically, the node is connected to ground through a resistor and a capacitor connected in series. Charge pump 10 charges the node when the UP control signal is asserted by sourcing an electrical current to the node. Charge pump 10 discharges the node when the DOWN control signal is asserted by sinking an electrical current from the node. One embodiment of the disclosed invention incorporates a charge pump 10 that has a programmable pump current. The pump current is the current that charges or discharges the node described above. A variable current allows charge pump 10 to behave consistently over a range of divide-by circuit settings. Such a charge-pump would receive a control signal to select what electrical current would be necessary to maintain a selected operating characteristic given. As depicted, charge-pump 10 receives a control signal labeled FREQUENCY CONTROL. Application for U.S. Patent entitled "A Charge Pump with a Programmable Pump Current and System," serial number 08/070,186, filed June 2, 1993, describes a charge pump that may be incorporated into PLL 22.

VCO 16 generates a periodic clock signal, VCO OUT, responsive to the voltage present on the node of charge pump 14. VCO 16 may have within it a ring oscillator connected to a first and a second power rail through a first and a second transistor, respectively. Generally, an increase in the voltage present on output node 12 causes the conductivity of the first or second transistors to increase, thereby increasing the oscillation frequency of the ring oscillator. Conversely, a decrease in the voltage present on output node 12 causes the conductivity of the first or second transistors to decrease, thereby decreasing the oscillation frequency of the ring oscillator.

Divide-By-N circuit 24 receives the signal VCO OUT and reduces the frequency of the signal by a ratio N. The output of divide-by-N circuit 22 generates the output of PLL 22 (labeled PLL OUT). Divide-By-M circuit 18 receives the signal PLL OUT and further reduces the frequency of the signal VCO OUT by a ratio M. Divide-By-P circuit 20 receives the signal REFERENCE CLOCK and reduces the frequency of the signal by a ratio P. The output of divide-by-M circuit 18 and divide-By-P circuit 20 are input to phase/frequency detector 12. It is these two signals which phase/frequency detector 12 aligns.

PLL 22 can generate an output clock signal that has a frequency different from the reference clock signal with the addition of divide-by-M circuit 18 or divide-by-P circuit 20. The frequency of the output clock signal, $\nu_{PLL\ OUT}$, is given by the relation:

$$\nu_{PLL\ OUT} = (M/P)\nu_{IN}$$

where M and P are the ratios described above and where $\nu_{IN}$ is the frequency of the input signal REFERENCE CLOCK. In the depicted embodiment, divide-by-M circuit 18 and divide-by-P circuit 20 receive a control signal labeled FREQUENCY CONTROL. It should be understood that the control signal FREQUENCY CONTROL may contain several signals or sets of signals. The control signal FREQUENCY CONTROL selects the divisor of divide-by-M circuit 18 and divide-by-P circuit 20. Divide-by-M circuit 18 and divide-by-P circuit 20 are individually programmable. Therefore, PLL 22 may generate a clock signal with different frequencies depending upon the settings of the inserted divider circuits. Application for U.S. Patent entitled "Delay Matching Circuit," serial number 08/043,112, filed April 5, 1993, describes a divide-by-P circuit that may be incorporated into PLL 22.

The frequency of the output of VCO 16 (labeled VCO OUT) is not necessarily equal to the frequency of the output signal (labeled PLL OUT). The frequency of the signal VCO OUT, $\nu_{VCO\ OUT}$, is given by the relation:

$$\nu_{VCO\ OUT} = (M^*N/P)^*\nu_{IN}$$

where M, N and P are the real numbers described above and where $\nu_{IN}$ is the frequency of the input signal REFERENCE CLOCK. The control signal FREQUENCY CONTROL also selects the divisor of divide-by-N circuit 24. The advantages of the disclosed invention are best understood with respect to TABLEs 1 and 2 described below.

In general, the advantages of PLL 22 may be described through two examples. In the first example, PLL 22 is programmed to generate a signal having a frequency equal to some predetermined ratio times the frequency of the reference signal. (For purposes of simplifying the following explanation, P is assumed to equal one.) Therefore, it is the PLL's function to match the frequency and phase of the reference signal, generally a constant frequency signal. In the second example, PLL 22 is programmed to generate an output signal having a frequency equal to some varying ratio times the frequency of the reference signal. In this second example, the reference signal may be assumed to have a generally constant frequency. Therefore, it is the PLL's function to change the frequency of the output signal, typically in large increments. The above described functional bifurcation is arbitrary and for purposes of illustrating the disclosed PLL. In a real application, the disclosed invention could be used to both match a generally constant frequency reference signal and vary the ratio of the frequencies of the input and output signals.

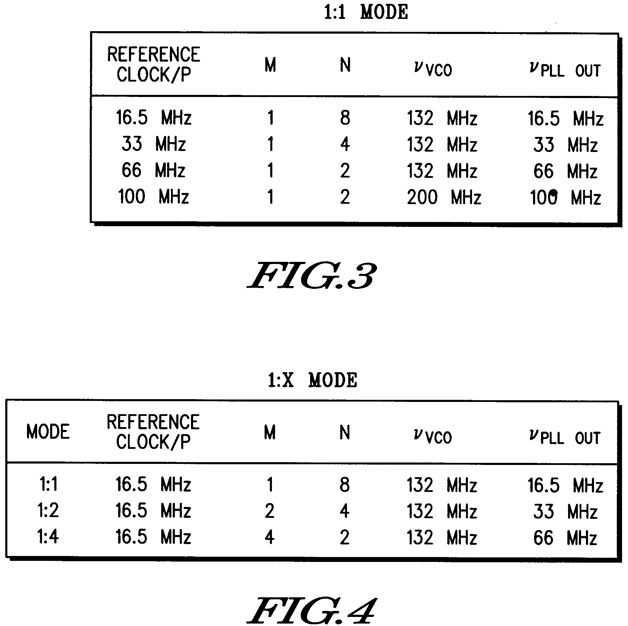

FIG. 3 depicts in tabular form four configurations of PLL 22 illustrated in FIG. 2. FIG. 2 depicts a first mode of operation of PLL 22. In these four configurations, PLL 22 is required to output a clock signal that matches some predetermined ratio of the input reference signal. Here the ratio is 1:1. However, in each of these four configurations, the frequency of the input signal differs. The frequency of the reference signal might vary if the signal itself varied or if PLL 22 was designed to operate in an environment where the reference clock could have any one of several values. In this particular example, the frequency of the input clock signal varies from 16.5 MHz to 100 MHz. As described above, the ratio (M/P) determines the ratio of the output clock signal and the input clock signal. Therefore, programming M = 1 forces the frequency of the output clock signal to match the frequency of the input clock signal. The frequency of VCO 16 may be modified independent of the output frequency by varying N. The frequency of the VCO OUT signal may be maintained at 132 MHz in the first through third configurations by varying N from eight to four to two. The frequency of the VCO OUT signal increases to 200 MHz in the fourth configuration.

In general, the required bandwidth of a VCO in a particular application is the difference between the maximum and minimum VCO frequency required in the application. In the first example, the bandwidth of the VCO is 68 MHz (200 MHz - 132 MHz). The bandwidth of a known VCO designed to operate in four configurations similar to those depicted in TABLE 1 is 167 MHz. Such a known PLL has a divide-by-M circuit with M equal to two (to insure a 50% duty cycle) and no divide-by-N circuit. The VCO in this known PLL would operate at 33 and 200 MHz in the first and fourth configurations, respectively. The disclosed PLL significantly increases the capabilities of a given VCO or conversely, eases the manufacturing process and the physical property limitations for a given circuit specification.

FIG. 4 depicts in tabular form three configurations of PLL 22 illustrated in FIG. 2. FIG. 2 depicts a second mode of operation of PLL 22. In these three configurations, PLL 22 is required to output a clock signal that matches a particular ratio of the input reference signal. The particular ratio varies in each configuration. The input signal input frequency remains constant. The ratio of frequencies might vary if, for instance, PLL 22 was part of a data processor designed to operate in an environment in which the data processor and its bus operated at different frequencies. In this particular example, the frequency ratios are 1:1, 1:2, and 1:4 and the input clock signals is a constant 16.5 MHz. As described above, the ratio (M/P) determines the ratio of the output clock signal and the input clock signal. Therefore, programming M = 1,2 and 4 forces the ratio of the frequency of the output clock to the frequency of the input clock to match the required ratios in the first, second and third configurations, respectively (P = 1). Simultaneously therewith, the value of N may be varied so that the product (N*M) is constant. In this example, the product (N*M) is a constant value of eight value. This mode of operation maintains a constant VCO frequency of 132 MHz. A circuit incorporating PLL 22 may switch between these three configurations without changing the frequency of VCO 14. This operating strategy is known as "switching on the fly." Divide-by-N circuit 24 allows PLL 22 to relock input and output clock signals after a ratio change with little or no delay.

Although the present invention has been described with reference to a specific embodiment, further modifications and improvements will occur to those skilled in the art. For instance, divide-by-P circuit 20 is not necessary to practice the disclosed invention. Also, the particular range of frequency reductions that divide-by-M circuit 18 and divide-by-N circuit 24 are each capable of is implementation specific. It is to be understood therefore, that the invention encompasses all such modifications that do not depart from the spirit and scope of the invention as defined in the appended claims.

**Claims**

1. A phase locked loop (22) for generating an output clock signal comprising:

   a phase/frequency circuit (12) for receiving a first clock signal and a second clock signal, the phase/frequency circuit generating a first control signal responsive to a predetermined phase relationship between the first and second clock signals, the first clock signal characterized by a first frequency, the second clock signal characterized by a second frequency;

   a charge pump circuit (14) coupled to the phase/frequency circuit, the charge pump circuit generating a voltage responsive to the first control signal;

   a voltage controlled oscillator circuit (16) coupled to the charge pump circuit, the voltage controlled oscillator circuit generating a third clock signal, the third clock signal characterized by a third frequency, the third frequency responsive to the voltage;

   a first divide-by circuit (24) coupled to the voltage controlled oscillator circuit, the first divide-by circuit generating an output clock signal, the output clock signal characterized by a fourth frequency, a ratio of the third and fourth frequencies being responsive to a second control signal; and

   a second divide-by circuit (18) coupled to the first divide-by circuit, the second divide-by circuit generating the first clock signal, the ratio of the first and fourth clock signals being a predetermined ratio.

2. A method of generating an output clock signal comprising the steps of:

   receiving a first clock signal and a second clock signal at a phase/frequency circuit, the first clock signal characterized by a first frequency, the second clock signal characterized by a second frequency;

   generating a first control signal at the phase/frequency detector responsive to a predetermined phase relationship between the first and second clock signals;

   generating a voltage by a charge pump circuit responsive to the first control signal;

   generating a third clock signal by a voltage controlled oscillator, the third clock signal characterized by a third frequency, the third frequency responsive to the voltage;

   generating an output clock signal by a first divide-by circuit, the output clock signal characterized by a fourth frequency, a ratio of the third and fourth frequencies being responsive to a second control signal; and

   generating the first clock signal by a second divide-by circuit, a ratio of the first and the fourth frequencies being a predetermined ratio.

3. A method of generating an output clock signal comprising the steps of:

   at a first time, receiving a first clock signal and a second clock signal at a phase/frequency circuit, the first clock signal characterized by a first frequency, the second clock signal characterized by a second frequency;

   generating a first control signal at the phase/frequency detector responsive to a predetermined phase relationship between the first and second clock signals;

   generating a voltage by a charge pump circuit responsive to the first control signal;

   generating a third clock signal by a voltage controlled oscillator, the third clock signal characterized by a third frequency, the third frequency responsive to the voltage;

   generating an output clock signal by a first divide-by circuit, the output clock signal characterized by a fourth frequency, a ratio of the third and fourth frequencies being responsive to a second control signal;

   generating the first clock signal by a second divide-by circuit, a ratio of the first and fourth frequencies being responsive to a second control signal; and

   at a subsequent second time, generating the third clock signal by the voltage controlled oscillator, the third clock signal characterized by the third frequency, the third frequency responsive to the voltage, the third frequency at the subsequent second time equal to the third frequency at the first time;

   generating the output clock signal by the first divide-by circuit, the output clock signal characterized by a fifth frequency, a ratio of the third and fifth frequencies responsive to the second control signal, the fifth frequency different from the fourth frequency;

generating the first clock signal by a second divide-by circuit, a ratio of the first and fifth frequencies being responsive to the second control signal.

_10_

# FIG.1
-PRIOR ART-

_22_

# FIG.2

## 1:1 MODE

| REFERENCE CLOCK/P | M | N | $\nu_{VCO}$ | $\nu_{PLL\ OUT}$ |
|---|---|---|---|---|
| 16.5 MHz | 1 | 8 | 132 MHz | 16.5 MHz |
| 33 MHz | 1 | 4 | 132 MHz | 33 MHz |
| 66 MHz | 1 | 2 | 132 MHz | 66 MHz |
| 100 MHz | 1 | 2 | 200 MHz | 100 MHz |

# FIG.3

## 1:X MODE

| MODE | REFERENCE CLOCK/P | M | N | $\nu_{VCO}$ | $\nu_{PLL\ OUT}$ |
|---|---|---|---|---|---|
| 1:1 | 16.5 MHz | 1 | 8 | 132 MHz | 16.5 MHz |
| 1:2 | 16.5 MHz | 2 | 4 | 132 MHz | 33 MHz |
| 1:4 | 16.5 MHz | 4 | 2 | 132 MHz | 66 MHz |

# FIG.4

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | EP-A-0 072 271 (THOMSON-CSF)<br>* page 3, line 4 - page 7, line 13; figures * | 1,2 | H03L7/183 |
| A | | 3 | |
| | --- | | |
| Y | RCA REVIEW,<br>vol.47, March 1986, PRINCETON US<br>pages 78 - 87<br>RICHARD YEAGER 'Loop Gain Compensation in Phase-Locked Loops'<br>* page 79, line 8 - line 16 *<br>* page 83, line 3 - page 87, line 13; figures 3-5 * | 1,2 | |
| A | | 3 | |
| | ----- | | |

TECHNICAL FIELDS
SEARCHED      (Int.Cl.6)

H03L

The present search report has been drawn up for all claims

| Place of search | Date of completion of the search | Examiner |
|---|---|---|
| THE HAGUE | 9 November 1994 | Balbinot, H |

EPO FORM 1503 03.82 (P04C01)